# EUROPEAN PATENT SPECIFICATION

(11) **EP 2 324 139 B1**
(45) Date of publication and mention of the grant of the patent: **19.07.2017**
(21) Application number: 09784775.0
(22) Date of filing: 22.07.2009
(51) Int. Cl.: C23C 14/35

(54) **APPARATUS AND METHOD FOR DEPOSITION OF MATERIAL TO FORM A COATING**
VORRICHTUNG UND VERFAHREN ZUR ABLAGERUNG EINES MATERIALS ZWECKS FORMUNG EINER BESCHICHTUNG
APPAREIL ET PROCÉDÉ POUR LE DÉPÔT D'UN MATÉRIAU POUR FORMER UN REVÊTEMENT

(30) Priority: 27.08.2008 CN 200820112365 U
(43) Date of publication of application: 25.05.2011
(73) Proprietor: Teer Coatings Limited, Droitwich WR9 9AS (GB)
(72) Inventor: TEER, Dennis, Droitwich WR9 9AS (GB)
(74) Representative: Wood, Graham
(86) International application number: PCT/GB2009/001823
(87) International publication number: WO 2010/023423

(56) References cited:
- WO-A-2008/003973
- GB-A- 2 340 845
- US-A- 5 556 519
- US-A1- 2003 129 407
- YANG SHICAI ET AL: "Applications of Cr-based metal nitride hard coatings using multi-magnetron sputtering sources and elemental metal targets" CAILIAO RECHULI XUEBAO = TRANSACTIONS OF MATERIALS AND HEATTREATMENT, CAILIAO RECHULI XUEBAO, CN, vol. 25, no. 5, 1 October 2004 (2004-10-01), pages 821-826, XP009093174 ISSN: 1009-6264

## Description

This invention relates to equipment for the Physical Vapour Deposition technique of magnetron sputter ion plating, that is to say for depositing materials in atomic and/or ionic form onto a receiving substrate by electrical discharge, for example to form coatings thereon.

Sputtering is a well known process in which a cathode of a glow discharge is made a target for ions produced in the glow discharge in a surrounding low-pressure gas. The ions are accelerated towards the target by an electric field and the impact of them on the target displaces particles of the surface of the target; these particles are deposited on the surface of a suitably placed substrate to form the coating. It is known that the intensity of the glow discharge can be increased significantly by a magnetron effect, which causes the ionisation electrons to be trapped in a region where the electric field is crossed by an added magnetic field. This is the basis of magnetron sputtering, which gives deposition rates approximately ten times those from non-magnetron electrodes and also allows sputtering to take place at much lower gas pressures. Magnets are placed to produce lines of force passing across and above the surface of the target.

Ion plating is a well known process in which a metal vapour produced in a vacuum system is deposited onto a substrate whilst, simultaneously, the substrate is bombarded with ions. The ion bombardment improves both the adhesion and the structure of the coating.

The metal vapour for ion plating can be produced by several techniques including sputtering. If sputtering is used as the vapour source in ion plating, the technique is called sputter ion plating. If magnetron sputtering is used as the vapour source in ion plating the technique is called magnetron sputter ion plating.

In ion plating, the ions which bombard the sample during deposition can be produced by several methods. In the basic ion plating method the ions are produced in an abnormal glow discharge with the samples acting as the cathode. This is an inefficient process and typically less than 1 atom in 1000 is ionised in an abnormal glow discharge. The ion current to the samples is low, and is not sufficient to produce the dense coatings required in many applications, even though the samples are held at a high negative potential.

The ionisation can be increased in several ways. For example, the supply of ionising electrons can be increased by means of a hot filament and an electrode which is positive with respect to the filament, or a hollow cathode can also be used to provide a copious supply of electrons.

Rather than use additional filaments and electrodes to provide ionisation enhancement, it is convenient to use a vapour source that itself can act as a source of ionisation. A hot filament electron beam gun evaporator, a resistance heated crucible, and a simple diode sputter electrode are commonly used deposition sources that create little extra ionisation. On the other hand, hollow cathode electron beam guns, glow discharge beam guns and arc sources all produce intense ionisation at a level of over 50% ionisation without the need for additional ionisation enhancement devices, and consequently can be used to produce very dense coatings in ion plating systems.

Magnetron sputtering electrodes have been used in ion plating systems and they do increase the ionisation, but in the past this has not been sufficient to affect the coating structure and to produce dense coatings. A recent development has been the use of an unbalanced magnetron which has inner and outer magnets and in which the field strength of the outer magnets is much higher than the field strength of the inner magnets.

The 'extra' field lines leaving the outer magnets trap electrons escaping from the magnetron discharge and prevent them from drifting to the various earthed parts of the chamber. These electrons cause ionisation in the vicinity of the electrically biased substrate and the ions so formed are attracted to the substrate by the substrate bias, and the substrates receive a higher ion current than in a situation where the magnetrons are balanced. However, the intensity of ionisation may still be less than is desirable for the deposition of dense coatings, unless the outer magnets are made exceptionally strong. It is thus clear that there are many ways of creating ions for sputtering or ion plating. US5556519 discloses one known form of a closed field material deposition apparatus and method.

The aim of the invention is to provide an improved magnetron sputter ion plating system, with an increased intensity of useful ionisation.

According to the invention in a first aspect there is provided a magnetron sputter ion plating apparatus comprising electric field means for producing an electric field directed towards at least one substrate to be coated and magnetic field means, the magnetic field means comprising at least two magnetrons and/or magnet assemblies each having an inner portion and an outer portion of opposite polarity, the magnetrons or magnet assemblies arranged such that the outer portion of at least one of the magnetrons or magnet assemblies has a first polarity and an adjacent magnetron or magnet assembly has an outer portion with opposite polarity so that magnetic field lines extend between said magnetrons and /or magnet assemblies and substantially prevent the escape of electrons from the system between the magnetrons and/ or magnet assemblies, and characterised in that two, spaced apart, plates are provided at floating potential, with one of the said plates at the top and the other of the said plates at the bottom in the apparatus and the at least one substrate is held at a negative electrical potential of up to -1000 Volts.

In one embodiment the magnetrons and/or magnet assemblies are arranged so that adjacent magnetrons and magnet assemblies have outer rings of opposite polarities.

The inner pole can be a single magnet, or a line or group of magnets. The outer "ring" pole can be formed from a single magnet or several separate magnets side by side. The "ring" need not be cylindrical or circular, but could be of square shape, or indeed any suitable figure.

The linking of the two magnetrons and/or magnet assemblies by magnetic flux traps electrons in the system and increases the amount of ionisation which occurs. We can thus provide practical magnetron sputter ion plating systems that give significantly increased ionisation using either balanced magnetrons or unbalanced magnetrons or magnet assemblies with outer magnets of moderate field strength.

Preferably the outer, ring, poles are angularly spaced relative to the position of the substrate to be coated so that they subtend a substantial angle at that substrate.

The system may comprise a plurality of magnetrons and/or magnet assemblies the adjacent outer poles, or end regions, of which are of opposite polarities. The magnetrons and/or magnet assemblies are preferably arranged around the substrate and the substrate may have a generally central position between the magnetrons and/or magnet assemblies. Preferably the are equally-angularly spaced in a polygon or ring around the substrate. In one embodiment the arrangement is for a magnetron, then a magnet assembly, then a magnetron, and so on.

The electric field may be provided extending substantially radially between the substrate and the magnetrons and/or magnet assemblies, the substrate being at a negative electrical potential. The negative potential of the substrate may vary from zero up to substantially higher values, say -1000V.

The magnetron poles may comprise a target of source material from which ions are produced. Preferably there are an even number of magnetrons and/or Magnet assemblies.

The system may further comprise a pumping port to control the pressure of an ionising gas, such as argon, in the system.

According to a second aspect the invention comprises a method of magnetron sputter ion plating in which the magnetic flux between a plurality of magnetrons and/or magnet assemblies located in a coating chamber comprises a substantially closed ring which traps substantially all electrons which enter the ring within the ring, and characterised by holding two, spaced apart, plates, one of the said plates provided at the top and the other of the said plates provided at the bottom in the apparatus, at floating potential and applying a negative electrical potential to the at least one substrate of up to -1000 Volts.

In this way the ion density in the plating system is significantly increased.

In one embodiment the apparatus is provided with a plurality of magnetrons. Alternatively the apparatus is provided with magnetrons and magnet assemblies, with the magnet assemblies positioned between respective magnetrons. In each case the polarities of the magnetrons and magnet assemblies outer portions are selected so as to be in accordance with the invention as herein described.

In one embodiment the substrates are cleaned, an adhesion layer of material is applied thereon, and a further layer of material is subsequently applied. Embodiments of the invention will now be described by way of example only with reference to the accompany drawings of which:
Figure 1a and b schematically illustrate a magnetron sputter ion plating system comprising two magnetrons and illustrating an arrangement of magnetic polarities in accordance with the invention;
Figure 2 schematically illustrates another system and shows the arrangement of magnetic polarities when two magnetrons are side by side;
Figure 3 illustrates schematically a practical version of a magnetron sputter ion plating system;
Figure 4 shows the improvement in ion current of the embodiment of Figure 3 in comparison with a known system;
Figure 5 illustrates another practical embodiment of the invention;
Figure 6 shows a magnetron sputter ion plating system similar to that of Figure 3, but modified;
Figure 7 shows a still further embodiment of the invention;
Figure 8 shows a magnetron sputter ion plating system having four magnetron pole assemblies;
Figure 9 is a graph comparing the ion current to a substrate against the bias; and
Figure 10 illustrates a variation on the apparatus of Figure 8.

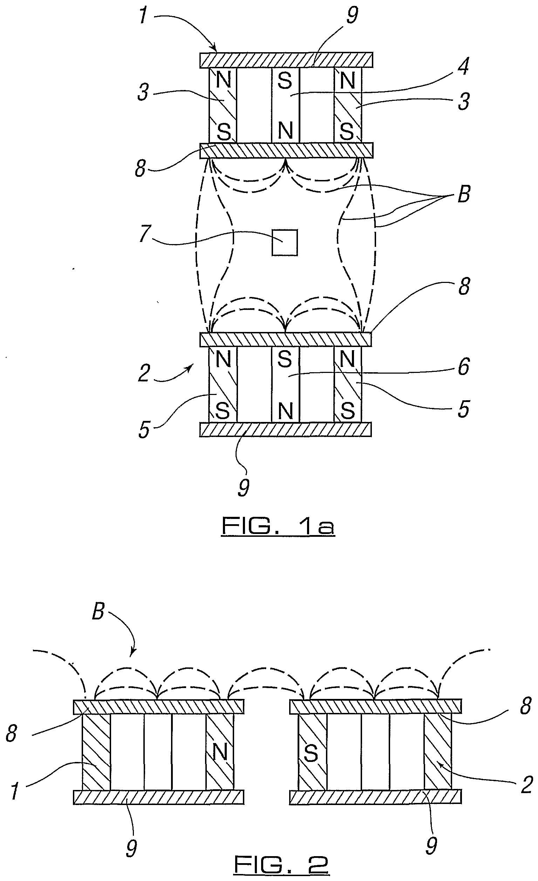

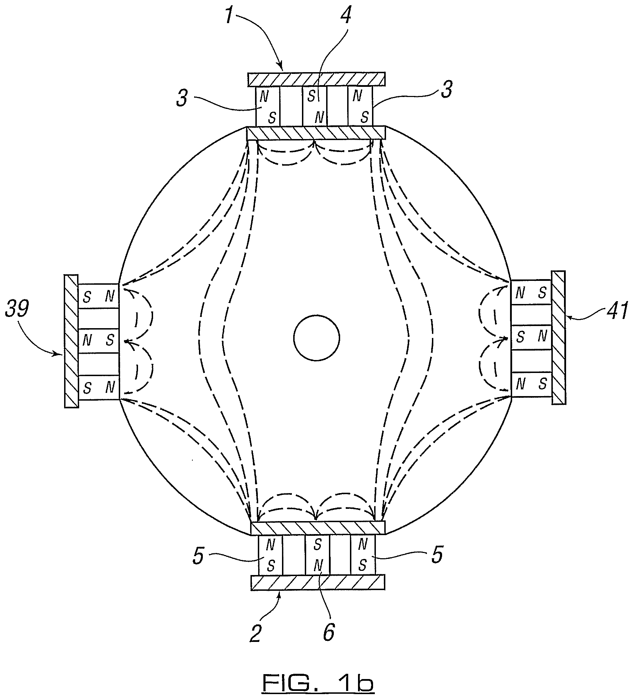

Figures 1a and b and 2 schematically show the basic concept behind the present invention. In Figures 1a and b two magnetrons 1 and 2 each have an outer ring magnet 3 and a central core magnet 4. In Figure 1a, which may be a practical arrangement, the outer magnet 3 of magnetron 1 is of "south" polarity and the inner core magnet 4 is of "north" polarity (in their regions adjacent a substrate 7). The outer magnet 5 of magnetron 2 is of north polarity and its core 6 of south polarity (in their regions adjacent the substrate 7). Thus, the magnetic field lines of magnetrons 1 and 2 form a continuous barrier, trapping electrons which diffuse from the magnetron plasmas.

Figure 1a and b also show the substrate 7 to be coated, target shrouds 8 of source material covering the exposed faces of the magnetron poles, and the magnetic field B. The magnetron poles have a soft iron backing plate 9 to complete their internal magnetic circuits.

As will be seen from Figures 1a and b, the magnetic field B fully surrounds the substrate 7 and serves to form a ring within which electrons are trapped. Since the electrons cannot escape the system they are available to enhance the ionisation associated with the substrate, creating a higher ion density than was previously possible.

Figure 2 illustrates two magnetron pole assemblies disposed side by side, the magnetic flux B still bridging the gap between the assemblies and preventing the escape of electrons through the gap between them.

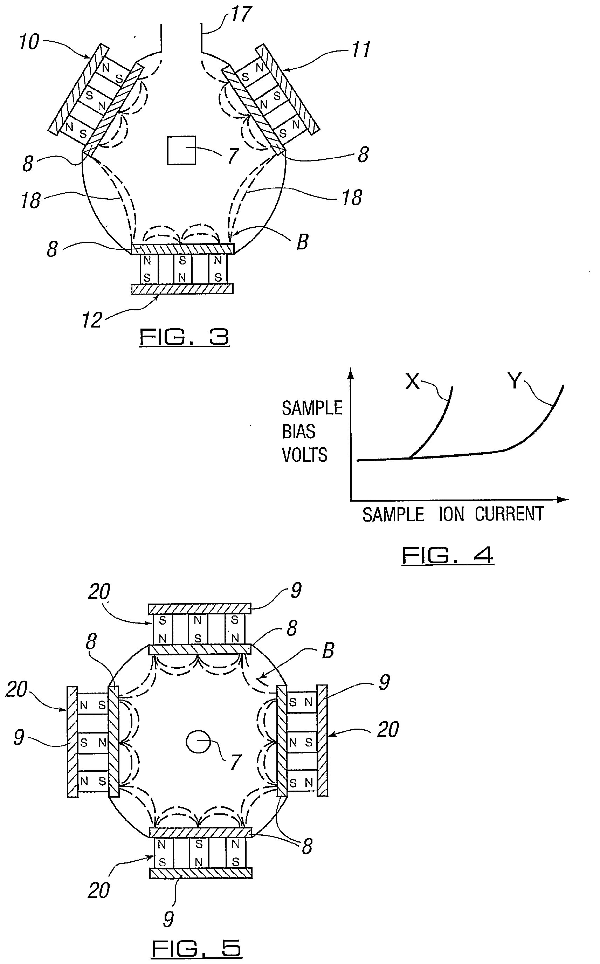

Turning to Figure 3, this illustrates a practical form of the invention. Three magnetron pole assemblies 10, 11, 12 are provided approximately equi-angularly spaced with the substrate 7 at the centre of the triangle. Adjacent outer magnetic assemblies of the magnetrons 10 and 12 and 11 and 12 respectively are of opposite polarity. A pumping port 17 is provided between the two adjacent poles of similar polarity of assemblies 10 and 11.

Magnetic field lines 18 extend from the adjacent ends of the magnetrons 10 and 12, and the magnetrons 11 and 12 and prevent the escape of electrons through the gaps between the magnetrons 10 and 12 and 11 and 12.

Thus electrons cannot escape to earthed parts of the system, except in the region of the pumping port.

In use an inert gas such as argon is provided in the chamber of the system and electrons are accelerated in the chamber by a potential difference applied to the magnetron targets 8 to ionize the gas, producing more electrons and argon ions. The argon ions present in the chamber bombard the targets 8 of source material and produce a coating flux of source material. The argon ions also bombard the substrate. The magnetic field lines B serve to form a continuous barrier to the electrons diffusing from the magnetron discharges and ensure that these electrons are not lost to the system without performing their useful function of enhancing the glow discharge associated with the negatively electrically biased substrates, increasing the ion current to the substrate. It should be appreciated that in each of the examples shown one or more magnetrons may be replaced by a magnet assembly with the same magnetic arrangement to maintain the magnetic flux.

Figure 4 illustrates the improvement which the present invention can achieve. Line X shows the ion current available for different bias voltages in an arrangement similar to that of Figure 3, but with each magnetron pole assembly being identical (for example, all three magnetrons having outer magnet assemblies with south poles akin to magnetrons 10 and 11) so that there is no flux between adjacent magnetrons. Line Y shows the ion current produced by the embodiment of Figure 3 which is far higher because of the flux between adjacent assemblies trapping ionising electrons.

Figure 5 shows another practical embodiment of a magnetron sputter ion plating system. Four magnetrons 20 are provided equi-angularly spaced in a ring with the substrate 7 at is centre. Each magnetron is similar to those described in Figure 1 and similar components have been given similar reference numerals.

A pumping port (not shown) is provided out of the plane of the four magnetrons, for example the system may have the overall cylindrical shape of a dustbin and the pumping port may be provided at the base of the dustbin, with the magnetrons, and substrate, above the base.

The magnetic field B forms a continuous ring surrounding the substrate and traps electrons in the ring. Since an even number of magnetron pole assemblies is provided the flux ring can be complete.

There is an advantage in providing an even number of magnetrons and/or magnet assemblies. Six or eight magnetron pole assemblies are also considered good configurations, but clearly more could be provided if desired. Adjacent magnetrons would have outer magnet assemblies of opposite polarity.

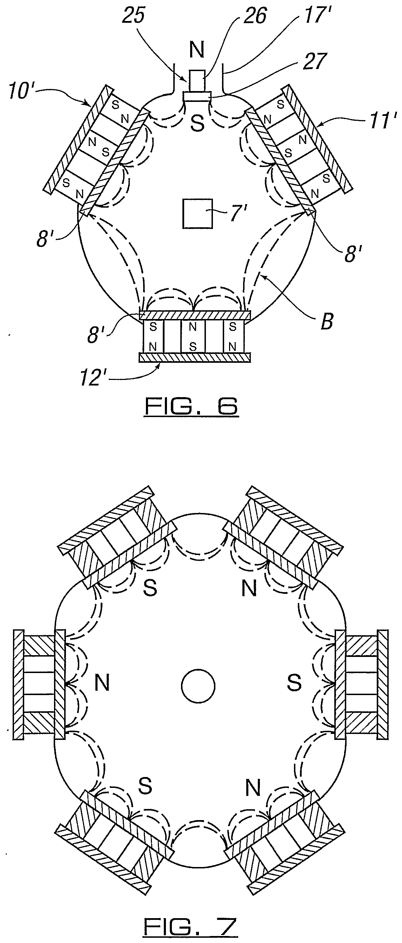

Figure 6 illustrates a system similar to that of Figure 3, but modified to alleviate the loss of ionising electrons at the region between the two pole assemblies near to the pumping port. Similar components have been given similar reference numerals.

An electrode component 25 is provided between the adjacent poles of the same polarity of magnetrons 10' and 11', with the component 25 providing an additional magnetic pole of opposite polarity between the two similar adjacent poles. The component 25 comprises a magnet 26 and a cap 27 of ferromagnetic material. The electrode component 25 is at a floating potential (it is insulated from earth). The magnetic field lines from magnetrons 10' and 11' are attracted to the magnetic electrode 25, so providing a closed trap for electrons.

The type of additional magnetic electrode shown in Figure 6 can be placed between neighbouring magnetron electrodes of similar polarity in a coating system to provide a barrier to the electrons escaping from the magnetron discharges, and so increase the intensity of ionisation and the ion current to the electrically biased substrates.

Figure 7 illustrates another embodiment of the invention which has six magnetron pole assemblies, with next-neighbour outer pole assemblies having opposite polarity.

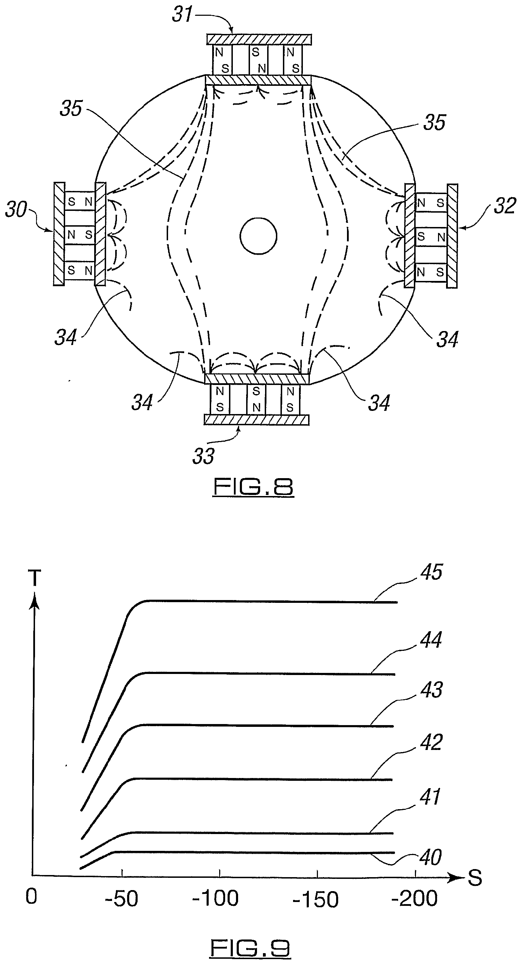

Figure 8 shows a magnetron sputter ion plating system having four magnetron pole assemblies 30, 31, 32 and 33. Pole assemblies 30 and 32 have alternate polarities, but pole assembly 33 presents poles of the same polarity to the adjacent portions of pole assemblies 30 and 32. Some magnetic field lines, lines 34, are not closed and escape the system.

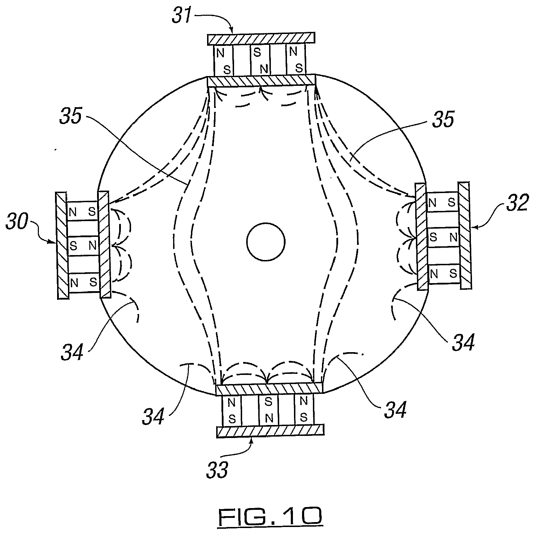

However, pole assemblies 31 and 33 also have magnetic field lines 35 connecting their regions of opposite polarity. A reasonable degree of magnetic closure still exists and we still achieve increased ionisation. An alternative arrangement of Figure 8 is shown in Figure 10 and discussed subsequently.

Even numbers of pole assemblies with next-neighbour assemblies being of opposite polarity are preferred (for example the embodiments of Figures 5 and 7), but other arrangements can work well.

Figure 9 compares the performance of different magnetron sputter ion plating systems. Axis S represents the bias voltage applied to the substrate (in volts), and axis T represents the ion current to the substrate target. Lines 40 to 45 exemplify the performance of magnetron system having the following characteristics:
Line 40 - Three pole assemblies (balanced) all of the same polarity and using ferrite magnets.
Line 41 - Three pole assemblies (unbalanced), all of the same polarity and using ferrite magnets.
Line 42 - Three mixed or alternating polarity magnetron pole assemblies (unbalanced), with ferrite magnets (as in the embodiment of Figure 3).
Line 43 - Three mixed or alternating polarity magnetron pole assemblies (unbalanced), with ferrite magnets, plus a dummy, or additional, pole assembly (as in the embodiment of Figure 6).
Line 44 - Four mixed or alternating polarity magnetron pole assemblies (unbalanced) with ferrite magnets.
Line 45 - Four mixed or alternating polarity magnetron pole assemblies (unbalanced) with Nd Fe B magnets.

The ionisation enhancement effect of the "mixed" polaritymagnetron s is effective even when relatively weak magnets such as ferrites are used. The ionisation enhancement effect is even greater when stronger magnetic materials, such as Neodymium Iron Boron are used.

Arrangements of three and four magnetrons as shown in Figure 3 and 5 have been used for the deposition of titanium nitride and other hard coats. The high ionisation produced by the 'mixed' magnetron effect is important in depositing coatings with high adhesion and hard dense structures.

In one embodiment the method includes the step of cleaning the substrates prior to the application of material thereon. The aim of the method is typically to provide a coating with a high quality dense structure and which has good adhesion. In accordance with the invention, in one example, the method includes depositing a one component coating, such as TiN, in a standard production process such as that shown in fig 5 with four Ti targets. Good adhesion is achieved by switching on the magnetrons at low power while applying a high bias on the substrates thus bombarding the substrates with energetic Ar ions. Because of the plasma enhancement from the (CF) system the bombardment is intense and produces very efficient cleaning. The power is increased on the magnetrons and the bias voltage reduced on the substrates in order to deposit under optimum conditions.The first adhesion layer is Ti about 0.2microns thick and then nitrogen is introduced to create the nitride coating.

For many advanced coatings, two component or three component coatings are applied, usually in the form of multi layers. One example of this in accordance with the current invention is the application of a CrAlTiN coating. If four magnetrons are provided as shown in Figure 5 and powered for the ion cleaning (as above), the power is then increased on the magnetrons while reducing the bias voltage on the substrates. This creates an adhesion layer of CrAlTi alloy. Such alloy coatings are usually highly stressed and can lead to adhesion failure. It is much better if the adhesion layer is a single metal element. In this case ion cleaning occurs with two Cr targets energised and the power is increased on these Cr targets to deposit a 0.2micron adhesion layer of Cr. and then power up the Al and Ti targets while introducing the nitrogen. It is important during this process that efficient ion cleaning occurs and the Cr adhesion layer is deposited with the best structure.

A suitable arrangement is shown in Fig 8 with 31 and 33 as Cr targets in opposing polarities and then 30 Al and 32 Ti both south polarities. ie this means that for many advanced coatings the arrangement of Fig 8 is the arrangement of choice.

For other coatings, such as the Graphit iC (TM-Teer Coatings Ltd) coating, Cr targets are used in the 31 and 33 positions for ion cleaning and depositing the adhesion layer and Carbon targets are used in the 30 and 32 positions.

Thus in accordance with the invention the apparatus can be used for the ion cleaning of substrates and for the application of the initial adhesion layer and then to subsequently change the operating parameters of the apparatus to perform the main deposition of the material onto the substrates to form the desired coating thereon.

In a further embodiment, the apparatus provides escape paths for the ionising electrons at the top and bottom of the coating system. In one embodiment plates are provided at floating potential at the top and bottom of the apparatus.

In one embodiment the method of use of the apparatus involves the steps of ion cleaning and then depositing an adhesion layer using magnetron targets 31 and 33 in the opposing polarity configuration and then subsequently the deposition of material from magnetron targets 30 and 32. This variation is shown in Figure 10.

In this case the deposition is solely from targets 30 and 32 and it is of advantage to have their polarities arranged such that one has an outer polarity arrangement of a first polarity and the other has an outer portion with an opposing polarity as shown in Figure 10.

In this case therefore 31 and 33 are provided with the opposing polarities as shown and 30 and 32 are also provided with opposing polarities. This is important for certain coatings such as MoST deposition where for example 31 and 33 can be used as Ti targets used to deposit a hard underlayer of TiN and then we would have 30 and 32 as MoS2 targets to deposit MoST in conjunction with a Ti target at low power.

The ion bombardment of the substrates is due to the ions formed in the glow discharge around the substrates being attracted to the substrates by the negative electrical bias voltage applied to the substrates. This bias voltage can be a DC voltage, or Radio Frequency power can be applied to the substrates in order to produce an induced negative voltage. The radio frequency technique is necessary when the substrates are of an electrically insulating material and/or when the coating material is electrically insulating, but can also be used when the substrates and the coating material are electrically conducting.

The improvements in coating adhesion and structure brought about by the increased ionisation due to the mixed magnetron polarity arrangement occur for both the DC and RF substrate bias.

## Claims

1. A magnetron sputter ion plating apparatus comprising electric field means for producing an electric field (E) directed towards at least one substrate (7;7') to be coated and magnetic field means(1,2;10,11,12;20), the magnetic field means comprising at least two magnetrons and/or magnet assemblies (1,2;10,11,12, 20) each having an inner portion and an outer portion of opposite polarity, the magnetrons or magnet assemblies arranged such that the outer portion of at least one of the magnetrons or magnet assemblies has a first polarity and an adjacent magnetron or magnet assembly (1;10) has an outer portion with opposite polarity so that magnetic field lines (B) extend between said magnetrons and /or magnet assemblies and substantially prevent the escape of electrons from the system between the magnetrons and/ or magnet assemblies, and **characterised in that** two, spaced apart, plates are provided at floating potential, with one of the said plates at the top and the other of the said plates at the bottom in the apparatus and the at least one substrate is held at a negative electrical potential of up to -1000 Volts.

2. Apparatus according to claim 1 wherein the magnetrons and/or magnet assemblies are arranged so that adjacent magnetrons and magnet assemblies have outer rings of opposite polarities.

3. Apparatus according to claim 1 **characterised in that** the outer poles are angularly spaced relative to the position of the substrate (7;7') to be coated so that they subtend a substantial angle at that substrate.

4. Apparatus according to claim 1 or claim 2, **characterised in that** the system comprises a plurality of magnetrons and magnet assemblies, the adjacent outer portions of which are of opposite polarities.

5. Apparatus according to claim 1, **characterised in that** the magnetrons and/or magnet assemblies (1,2;10,12) are arranged around the substrate (7;7') and the substrate has a generally central position between the magnetrons.

6. Apparatus according to claim 1, **characterised in that** the magnetrons and/or magnet assemblies are substantially equally-angularly spaced in a polygon or ring around the substrate.

7. Apparatus according to claim 1, **characterised in that** the magnetrons include a target (8;8') of material from which a coating flux is produced.

8. Apparatus according to claim 1, **characterised in that** there are at least three magnetrons and/or magnet assemblies.

9. Apparatus according to claim 1 wherein openings are provided at the top and/or bottom of the chamber in which the substrates are located to allow the escape of electrons therefrom.

10. Apparatus according to claim 1 wherein said layer of material which is deposited is the first layer of the coating which is deposited and acts as an adhesive layer.

11. Apparatus according to claim 1 **characterised in that** prior to applying the said layer of material a cleaning process is performed in which the substrates are biased and at least one of the magnetrons operated to direct ions onto the substrate surface to clean the same.

12. A method of magnetron sputter ion plating in which the magnetic flux between a plurality of magnetrons and/or magnet assemblies located in a coating chamber comprises a substantially closed ring which traps substantially all electrons which enter the ring within the ring, and **characterised by** holding two, spaced apart, plates, one of the said plates provided at the top and the other of the said plates provided at the bottom in the apparatus, at floating potential and applying a negative electrical potential to the at least one substrate of up to -1000 Volts.

13. A method according to claim 12 wherein magnetrons are initially operated with a bias applied to the substrates to bombard the substrates with ions to clean the surface onto which the coating is to be applied.

14. A method according to claim 12 wherein material is deposited from targets of a first material to apply a layer of material onto the at least one substrate surface to act as an adhesion layer for the coating to be formed prior to the material being applied to form the remainder of the coating.

15. A method according to claim 14 **characterised in that** the apparatus is used for the ion cleaning of the substrates and for the application of the adhesion layer and then subsequently changing the operating parameters of the apparatus to perform the main deposition of the material onto the substrates to form the desired coating thereon.

## Patentansprüche

1. Vorrichtung zum Ionenplattieren mittels Magnetronsputtern, umfassend eine Einrichtung für elektrische Felder zum Erzeugen eines elektrischen Felds (E), das auf wenigstens einen zu beschichtenden Träger (7; 7') gerichtet ist, und eine Einrichtung für magnetische Felder (1, 2; 10, 11, 12; 20), wobei die Einrichtung für magnetische Felder wenigstens zwei Magnetrone und/oder Magnetanordnungen (1, 2; 10, 11, 12, 20) umfasst, die jeweils einen Innenteil und einen Außenteil mit entgegengesetzter Polarität haben, wobei die Magnetrone oder Magnetanordnungen so angeordnet sind, dass der Außenteil von wenigstens einem von den Magnetronen oder Magnetanordnungen eine erste Polarität hat und ein(e) angrenzende(s) Magnetron oder Magnetanordnung (1; 10) einen Außenteil mit entgegengesetzter Polarität hat, sodass magnetische Feldlinien (B) zwischen den genannten Magnetronen und/oder Magnetanordnungen verlaufen und das Entweichen von Elektronen aus dem System zwischen den Magnetronen und/oder Magnetanordnungen im Wesentlichen verhindern, und **dadurch gekennzeichnet, dass** zwei voreinander beabstandete Platten potentialfrei bereitgestellt werden, wobei eine der genannten Platten oben und die andere der genannten Platten unten in der Vorrichtung ist und der wenigstens eine Träger auf einem negativen elektrischen Potential bis zu -1000 Volt gehalten wird.

2. Vorrichtung nach Anspruch 1, wobei die Magnetrone und/oder Magnetanordnungen so angeordnet sind, dass angrenzende Magnetrone und Magnetanordnungen Außenringe entgegengesetzter Polaritäten haben.

3. Vorrichtung nach Anspruch 1, **dadurch gekennzeichnet, dass** die Außenpole relativ zur Position des zu beschichtenden Trägers (7; 7') winklig beabstandet sind, sodass sie einem beträchtlichen Winkel an diesem Träger gegenüberliegen.

4. Vorrichtung nach Anspruch 1 oder Anspruch 2, **dadurch gekennzeichnet, dass** das System mehrere Magnetrone und Magnetanordnungen umfasst, wobei die angrenzenden Außenteile davon eine entgegengesetzte Polarität haben.

5. Vorrichtung nach Anspruch 1, **dadurch gekennzeichnet, dass** die Magnetrone und/oder Magnetanordnungen (1, 2; 10, 12) um den Träger (7; 7') angeordnet sind und der Träger eine allgemein zentrale Position zwischen den Magnetronen hat.

6. Vorrichtung nach Anspruch 1, **dadurch gekennzeichnet, dass** die Magnetrone und/oder Magnetanordnungen in einem Polygon oder Ring um den Träger im Wesentlichen gleichwinklig beabstandet sind.

7. Vorrichtung nach Anspruch 1, **dadurch gekennzeichnet, dass** die Magnetrone ein Target (8; 8') aus Material beinhalten, aus dem ein Beschichtungsfluss erzeugt wird.

8. Vorrichtung nach Anspruch 1, **dadurch gekennzeichnet, dass** es wenigstens drei Magnetrone und/oder Magnetanordnungen gibt.

9. Vorrichtung nach Anspruch 1, wobei oben und/oder unten in der Kammer Öffnungen bereitgestellt sind, in denen sich die Träger befinden, um das Entweichen von Elektronen daraus zuzulassen.

10. Vorrichtung nach Anspruch 1, wobei die genannte Materialschicht, die aufgebracht wird, die erste Schicht der Beschichtung ist, die aufgebracht wird und als eine Haftschicht wirkt.

11. Vorrichtung nach Anspruch 1, **dadurch gekennzeichnet, dass** vor Auftragen der genannten Materialschicht ein Reinigungsprozess durchgeführt wird, bei dem die Träger vorgespannt werden und wenigstens eines der Magnetrone betätigt wird, um Ionen auf die Trägerfläche zu richten, um diese zu reinigen.

12. Verfahren zum Ionenplattieren mittels Magnetronsputtern, bei dem der magnetische Fluss zwischen mehreren in einer Beschichtungskammer befindlichen Magnetronen und/oder Magnetanordnungen einen im Wesentlichen geschlossenen Ring umfasst, der im Wesentlichen alle Elektronen, die in den Ring eintreten, in dem Ring einschließt, und **gekennzeichnet durch** Potentialfrei-Halten von zwei voreinander beabstandeten Platten, wobei in der Vorrichtung eine der genannten Platten oben bereitgestellt ist und die andere der genannten Platten unten bereitgestellt ist, und Anlegen eines negativen elektrischen Potentials an den wenigstens einen Träger bis zu - 1000 Volt.

13. Verfahren nach Anspruch 12, wobei Magnetrone anfänglich mit einer Vorspannung betrieben werden, die an die Träger angelegt wird, um die Träger zum Reinigen der Oberfläche, auf welche die Beschichtung aufzutragen ist, mit Ionen zu beschießen.

14. Verfahren nach Anspruch 12, wobei Material von Targets aus einem ersten Material aufgebracht wird, um eine Materialschicht auf die wenigstens eine Trägerfläche aufzutragen, um als Haftschicht für die zu bildende Beschichtung zu wirken, bevor das Material zum Bilden des Rests der Beschichtung aufgetragen wird.

15. Verfahren nach Anspruch 14, **dadurch gekennzeichnet, dass** die Vorrichtung zur Ionenreinigung der Träger und zum Auftragen der Haftschicht und dann anschließendem Ändern der Betriebsparameter der Vorrichtung zum Durchführen der Hauptaufbringung des Materials auf die Träger zum Bilden der gewünschten Beschichtung daran verwendet wird.

## Revendications

1. Appareil de placage ionique à pulvérisation au magnétron comprenant des moyens de champ électrique pour produire un champ électrique (E) dirigé vers au moins un substrat (7 ; 7') destiné à être revêtu et des moyens de champ magnétique (1, 2 ; 10, 11, 12 ; 20), les moyens de champ magnétique comprenant au moins deux ensembles magnétrons et/ou aimants (1, 2 ; 10, 11, 12 ; 20) chacun possédant une portion interne et une portion externe à polarité opposée, les ensembles magnétrons ou aimants étant agencés de telle sorte que la portion externe d'au moins un des ensembles magnétrons ou aimants ait une première polarité et un ensemble magnétron ou aimant adjacent (1 ; 10) ait une portion externe avec une polarité opposée de sorte que des lignes de champ magnétique (B) s'étendent entre lesdits ensembles magnétrons et/ou aimants et empêchent sensiblement l'échappement d'électrons hors du système entre les ensembles magnétrons et/ou aimants, et **caractérisé en ce que** deux plaques, espacées l'une de l'autre, sont prévues à un potentiel flottant, alors que l'une desdites plaques se trouve au niveau du haut, et l'autre desdites plaques se trouve au niveau du bas de l'appareil, et ledit au moins un substrat est maintenu à un potentiel électrique négatif allant jusqu'à - 1000 Volts.

2. Appareil selon la revendication 1, les ensembles magnétrons et/ou aimants étant agencés de sorte que des ensembles magnétrons et aimants adjacents ont des anneaux externes de polarités opposées.

3. Appareil selon la revendication 1, **caractérisé en ce que** les pôles externes sont espacés angulairement par rapport à la position du substrat (7 ; 7') destiné à être revêtu, de sorte qu'ils sous-tendent un angle sensible au niveau de ce substrat.

4. Appareil selon la revendication 1 ou la revendication 2, **caractérisé en ce que** le système comprend une pluralité d'ensembles magnétrons et aimants, dont les portions externes adjacentes sont de polarités opposées.

5. Appareil selon la revendication 1, **caractérisé en ce que** les ensembles magnétrons et/ou aimants (1, 2 ; 10, 12) sont agencés autour du substrat (7 ; 7'), et le substrat occupe une position centrale de manière générale entre les magnétrons.

6. Appareil selon la revendication 1, **caractérisé en ce que** les ensembles magnétrons et/ou aimants sont espacés de manière sensiblement équidistante dans le plan angulaire dans un polygone ou un anneau autour du substrat.

7. Appareil selon la revendication 1, **caractérisé en ce que** les magnétrons incluent une cible (8 ; 8') de matériau à partir de laquelle un flux de revêtement est produit.

8. Appareil selon la revendication 1, **caractérisé en ce qu'**il existe au moins trois ensembles magnétrons et/ou aimants.

9. Appareil selon la revendication 1, des ouvertures étant prévues au niveau du haut et/ou du bas de la chambre dans laquelle les substrats sont localisés pour permettre aux électrons de s'échapper de celle-ci.

10. Appareil selon la revendication 1, ladite couche de matériau qui est déposée étant la première couche du revêtement qui est déposé et qui agit en tant que couche adhésive.

11. Appareil selon la revendication 1, **caractérisé en ce qu'**avant l'application de ladite couche de matériau, un processus de nettoyage est réalisé dans lequel les substrats sont polarisés et au moins l'un des magnétrons est exploité pour diriger des ions sur la surface du substrat afin de nettoyer cette dernière.

12. Procédé de placage ionique par pulvérisation au magnétron dans lequel le flux magnétique entre une pluralité d'ensembles magnétrons et/ou aimants localisés dans une chambre de revêtement comprend un anneau sensiblement fermé qui piège sensiblement tous les électrons qui entrent dans l'anneau au sein de l'anneau, et **caractérisé par** le maintien de deux plaques, espacées l'une de l'autre, l'une desdites plaques étant prévue au niveau du haut, et l'autre desdites plaques étant prévue au niveau du bas de l'appareil, à un potentiel flottant, et l'application d'un potentiel électrique négatif allant jusqu'à - 1000 Volts audit au moins un substrat.

13. Procédé selon la revendication 12, des magnétrons étant initialement exploités avec une polarisation laquelle est appliquée aux substrats pour bombarder les substrats avec des ions afin de nettoyer la surface sur laquelle le revêtement est destiné à être appliqué.

14. Procédé selon la revendication 12, du matériau étant déposé à partir de cibles d'un premier matériau afin d'appliquer une couche de matériau sur ladite au moins une surface de substrat pour agir en tant que couche d'adhésion pour le revêtement destiné à être formé avant que le matériau ne soit appliqué pour former le restant du revêtement.

15. Procédé selon la revendication 14, **caractérisé en ce que** l'appareil est utilisé pour le nettoyage ionique des substrats et pour l'application de la couche d'adhésion et puis ultérieurement le changement des paramètres opérationnels de l'appareil pour réaliser le dépôt principal du matériau sur les substrats afin de former sur ceux-ci le revêtement désiré.
